# EUROPEAN PATENT APPLICATION

(11) **EP 4 621 988 A1**
(43) Date of publication of application: **24.09.2025**
(21) Application number: 24165640.4
(22) Date of filing: 22.03.2024
(51) Int. Cl.: H01P 3/12, H01P 11/00, H01Q 1/22, H01P 3/08

(54) **METAL STRUCTURE FOR A COMPONENT CARRIER, AND MANUFACTURE METHOD**

(71) Applicant: AT & S Austria Technologie & Systemtechnik Aktiengesellschaft, 8700 Leoben-Hinterberg (AT)
(72) Inventor: GOESSLER, Michael, 8723 Kobenz (AT); SCHLICK, Daniel, 8733 St. Marein-Feistritz (AT); HEIMRATH, Roland, 8741 Weisskirchen (AT); EBNER, Claudia, 8583 Edelschrott (AT); CHRISTANDL, Robert, 8700 Leoben (AT)
(74) Representative: Dilg, Haeusler, Schindelmann Patentanwaltsgesellschaft mbH

(57) **Abstract**

There is described a metal structure (100) for a component carrier (150), wherein the metal structure (100) comprises:
i) a first metal layer structure (110) comprising a first recess (111) exposed to a first surface and defining a first external boundary profile (115); and
ii) a second metal layer structure (120) comprising a second recess (121) exposed to a second surface and defining a second external boundary profile (125).

The first metal layer structure (110) and the second metal layer structure (120) are stacked to face each other, so that the first recess (111) and the second recess (121) define a common recess (130), and the first external boundary profile (115) of the first recess (111) and the second external boundary profile (125) of the second recess (121) are misaligned in the stacking direction (Z) of the metal structure (100).

## Description

### Field of the Invention

The invention relates to a metal structure for a component carrier, wherein the metal structure comprises: a first metal layer structure comprising a first recess exposed to one first surface and defining a first external boundary profile, and a second metal layer structure comprising a second recess exposed to a second surface and defining a second external boundary profile. The first metal layer structure and the second metal layer structure are stacked to face each other, so that the first recess and the second recess define together a common recess. The invention further relates to a method of manufacturing said metal structure using an etching process. Further, the invention relates to a component carrier or antenna structure comprising the metal structure, and to an antenna assembly that comprises the metal structure.

Accordingly, the invention may relate to the technical field of component carriers, such as printed circuit boards or IC substrates, and their manufacture, in particular with respect to radio frequency (RF) applications.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

Radio frequency (RF) applications have become more and more important in the field of component carriers. For example, antenna (e.g. patch, slot, or waveguide antennas) or radar applications can be implemented in or coupled to component carriers. Yet, these technically/economically important applications may still be seen as a challenge with respect to signal quality and space requirements, in particular regarding waveguide antennas. Conventionally, RF structures such as a wave guide are manufactured by metallizing an electrically insulating (layer) structure. Nevertheless, such processes may be cost-intensive and the design-flexibility may be limited.

### Summary of the Invention

There may be a need to provide an RF front-end (e.g.
antenna/radar/waveguide, base station, small cells, etc.) application in the context of a component carrier in an efficient and reliable manner.

A metal structure, a component carrier, an antenna structure, an antenna assembly, and a method are described.

According to a first aspect of the invention, there is described a metal structure (e.g. a copper layer/foil) for a component carrier (e.g. a printed circuit board, an IC substrate, an antenna-functionality associated stack), wherein the metal structure comprises:
i) a first (upper) metal layer structure comprising a first recess (e.g. one or more blind hole(s) and/or through hole(s) and/or trenches) exposed to (at least) a first surface (in particular lower (main) surface) and defining a first external boundary profile (e.g. a sidewall portion and an edge portion), and
ii) a second (lower) metal layer structure comprising a second recess (e.g. one or more blind hole(s) and/or through hole(s) and/or trenches) exposed to (at least) a second surface (in particular upper (main) surface) and defining a second external boundary profile.

The first metal layer structure and the second metal layer structure are stacked (in the vertical or horizontal direction; one on the other or one next to the other) to face each other (arranged with respect to each other), so that the first recess and the second recess define (together) a common recess.

In particular, the first external boundary profile of the first recess and the second external boundary profile of the second recess (when forming the common recess) are misaligned in the stacking direction of the metal structure (thereby in particular reflecting a manufacture step of etching).

In an exemplary embodiment, the (first/second) recess may be exposed during manufacturing of the semi-finished product. However, in the final product the recess may not be exposed to an external environment.

According to a second aspect of the invention, there is described a component carrier, comprising:
i) a stack comprising at least one electrically insulating layer structure and/or at least one electrically conductive layer structure, and
ii) a metal structure as described above.
Hereby, the metal structure is arranged on at least one main surface of the stack and/or the metal structure is at least partially embedded in the stack.

According to a third aspect of the invention, there is described an antenna structure, comprising:
i) an opening and/or channel through at least a part of the antenna structure, and
ii) a metal structure as described above. Hereby, the common recess of the metal structure defines at least part of said opening/channel.

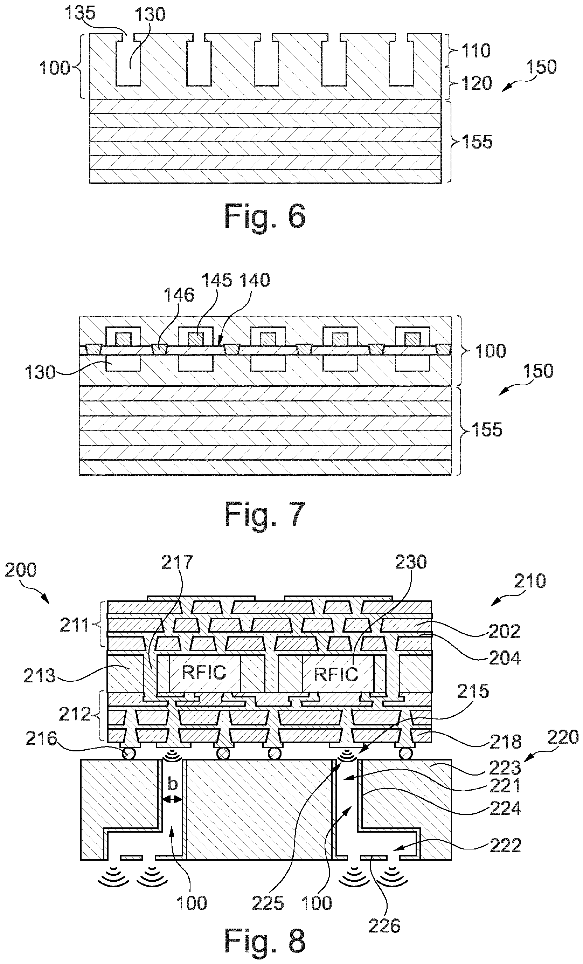

According to a fourth aspect of the invention, there is described an antenna assembly (see e.g. Figure 8), comprising:
i) a stack (in particular a component carrier), and
ii) an antenna structure as described above. The stack and the antenna stack may be (thermally and/or electrically) connected.

According to a fifth aspect of the invention, there is described a method of forming a metal structure for a component carrier, the method comprising:
i) removing material, in particular by etching, of a first metal layer structure to form a first recess exposed to a first surface and defining a first external boundary profile,
ii) removing material, in particular by etching, of a second metal layer structure to form a second recess exposed to a second surface and defining a second external boundary profile; and
iii) stacking the first metal layer structure and the second metal layer structure to face each other, so that the first recess and the second recess define a common recess.

In the present context, the term "metal structure" may in particular refer to a (layer) structure that comprises metal and is suitable to form one or more recesses therein by material removal, preferably by (wet chemical) etching (leading to structural features in the metal structure). Alternatively, other material removal processes may be applied, for example laser erosion and/or plasma etching. To form such a metal structure, a metal layer such as a copper foil may be used as a starting material. The recesses may be formed as blind holes and/or through holes and/or as trenches. For example, an etching process may be applied to remove metal material, leaving behind metal material structures (e.g. pillars or walls) with the recesses in between, respectively. Arranging two or more of such metal structures, may interconnect two or more recesses, thereby forming at least one common recess.

Preferably, the common recess may comprise an elongated shape, for example like a (closed) tube, wherein at least one extension of the common recess, for example the length, may be at least five times, in particular at least 10 times, longer than at least another extension, for example the width or hight. In an embodiment, the metal structure may be embedded in a component carrier and/or antenna structure. In another embodiment, the metal structure may be surface-mounted to a component carrier and/or antenna structure. The metal structure may be in particular configured for an RF front-end (antenna/radar) functionality. For example, the common recces may be configured as an opening (preferably to a channel), thereby providing a waveguide for an electromagnetic wave signal. Two or more recesses of a metal structure may have the same depth or different depths. Preferably, the respective depths of the recesses in the metal structure are well defined. This may be achieved by the above-mentioned etching process.

In the present context, the term "antenna structure" may refer to a structure suitable to implement an antenna (related) functionality. Such an antenna structure may be configured e.g. as a block or a (component carrier) stack. When the antenna structure is configured as (part of) a component carrier, the antenna structure may have less than seven layers, in particular less than three layers, in particular three layers (or less). In an embodiment, the antenna structure comprises an opening to a channel, preferably a channel going through the antenna structure. Such a channel may serve as a waveguide to guide an electromagnetic wave (e.g. provided by a launcher) at least partly within and/or through the antenna structure. For this purpose, the (side) walls of the channel may be (at least partially) coated/metallized.

Preferably, the coating of the side walls of the channel may be electrically conductive. Electrically conductive coating material may comprise a metal, e.g. copper or silver, which may bring the advantage of lower losses of electromagnetic waves when passing through the channel. In an embodiment, there may be the advantage that there is no need of a metalized coating on the sidewall, as the whole antenna stack is based on metal (e.g. copper). As two openings may be needed (one for the signal entrance, and one for the signal emission), a protective coating (limiting metal/copper oxidation) may be used.

The antenna structure may be further configured to serve as a mounting structure for a (component carrier) stack. In an embodiment, the antenna structure comprises a plurality of said openings/channels (in the horizontal direction) next to each other. These channels may be separated from each other or (at least partially) interconnected. Furthermore, the bottom side of the component carrier may be oriented towards the top side of the antenna structure.

In the present context, the term "face each other" may refer to the orientation/alignment of the first metal structure and the second metal structure with respect to each other. In particular, said term may refer to the orientation/alignment of the first recess and the second recess with respect to each other. In a first embodiment, the first recess and the second recess each have a center point/geometrical barycenter one aligned with the other along the stack thickness direction (e.g. vertical direction Z). A deviating tolerance may hereby be smaller than 30 µm, in particular smaller than 10 µm. In a second embodiment, the first recess and the second recess may each define an external planar surface, wherein said respective surfaces (at least partially) overlap (completely or partially) one to each other.

In the present context, the term "misalignment" may refer to a structural feature (defect) that reflects a process step of etching. A result of the misalignment may be small edges/steps, or a suddenly disrupted surface/interface between the metal structure and the channel. In an example, the "misalignment" may be +/- 10 µm or lower, dependent on the thickness of the metal structure/foil, etching depth, and final application.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier.

In an example, all layers of the component carrier may form the stack. In another example, only a part of the layers of the component carrier form the stack.

In this context, the term "layer structure" may in particular refer to a continuous or discontinuous layer (or separated islands within the same plane) of electrically conductive or electrically insulating material. A plurality of such layers, parallel stacked one upon the other, may form the stack in the vertical direction.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

In the present context, the term "external boundary profile" may in particular refer to the shape of a recess in a metal (layer) structure. The profile may hereby be defined by a sidewall portion and/or an edge portion and/or a wall/pillar between two neighboring recesses.

In the present context, the term "antenna assembly" may in particular refer to an assembly of (at least one) a (component carrier) stack and an antenna structure (see definitions above). The stack may be mounted on the antenna structure, e.g. connected by an interconnection structure. In a preferred example, the stack and the antenna structure are arranged with respect to each other, so that an electromagnetic wave coupling structure of the stack faces a corresponding channel opening of the antenna structure. In an embodiment, the wave coupling structure may serve as a launcher/transmitter/receiver of RF/HF signals. In a further embodiment, the channel may serve as a waveguide to guide the electromagnetic waves from the wave coupling structure.

According to an exemplary embodiment, the invention may be based on the idea that (a metal structure suitable for a component carrier, such as for) an RF front-end (e.g. antenna or radar) application can be provided in an efficient and reliable manner, when a first recess is formed in a first metal layer structure by a first etching, a second recess is formed in a second metal layer structure by a second etching, and wherein the metal layer structures are stacked (attached to each other), so that the first recess and the second recess together form a common recess. Said common recess may then be used for different applications, such as for an efficient and reliable RF front-end application, for example a wave guide channel or for a fluid flowing inside said recess.

Using an etching process, the dimensions (e.g. depth, shape, width, etc.) of the recesses may be controlled in a reliable manner (especially when surface active additives are used to propagate). The etching process may be done in a single step (e.g. etching done from top and bottom simultaneously). A large variety of recesses (e.g. blind recesses, through recesses, etc.) are possible, thereby enabling a high design flexibility. The starting material for such an etching process may be for example a copper foil (alternatively, other metals, e.g. nickel, chromium, tin, silver, etc. may be used), i.e. a common and unexpensive raw material from the component carrier manufacture. The etching process may be seen in the final (metal structure, component carrier) product for example by structural features such as a misalignment between the first and second recess, when the common recess has been formed.

Conventionally, wave guides are formed by metallizing a channel in electrically insulating material. According to the described disclosure, however, the wave guide channel itself may be formed in metal material in an efficient and highly accurate manner.

The present disclosure may provide many advantages. For example, the metal structure may be highly robust and thus provide stability to itself and/or a component carrier. The metal structure may be used as a design-flexible inlay that may be assembled (e.g. embedded in or mounted on a further structure such as a component carrier and/or antenna structure). The inlay may be manufactured separately from the component carrier. The metal structure may function as an efficient electromagnetic shielding structure. Further, the metal structure may be provided with a very thin height (in the z-direction), thus enabling efficient packing. The height of the metal foil may be dependent from the recess height, while the recess height may be dependent on the frequency (especially the joint recess should be in line with the wavelength). Additionally, the metal structure may be at least partially used for thermal management (e.g. cooling, heat transfer, etc.).

Furthermore, the formation of the recesses on the metal structures through the known subtractive processes (such as etching, laser erosion) on two faced metal layer structures, resulting in the misalignment of the respective externally boundary profiles of the recesses, may result in a cheap and easy way to manufacture the metal structure with (internal) recesses.

### Exemplary Embodiments

In an embodiment, the common recess has an irregular profile, in particular along the stacking direction (e.g. the vertical direction Z). For example, the sidewalls of the common recess may be formed at least partially irregular. In a further example, the first recess and the second recess comprise at least partially different profiles. This structural feature may reflect the advantageous manufacture process by etching or eventually laser, which may result in (partially) irregular profiles. In this document, the term "irregular profile" may denote a non-planar lateral surface of the common recess having a plurality of indentations and/or protrusions. Additionally or alternatively, the irregular profile may have round shaped and/or sharp corners and/or edges pointing inwardly and/or outwardly.

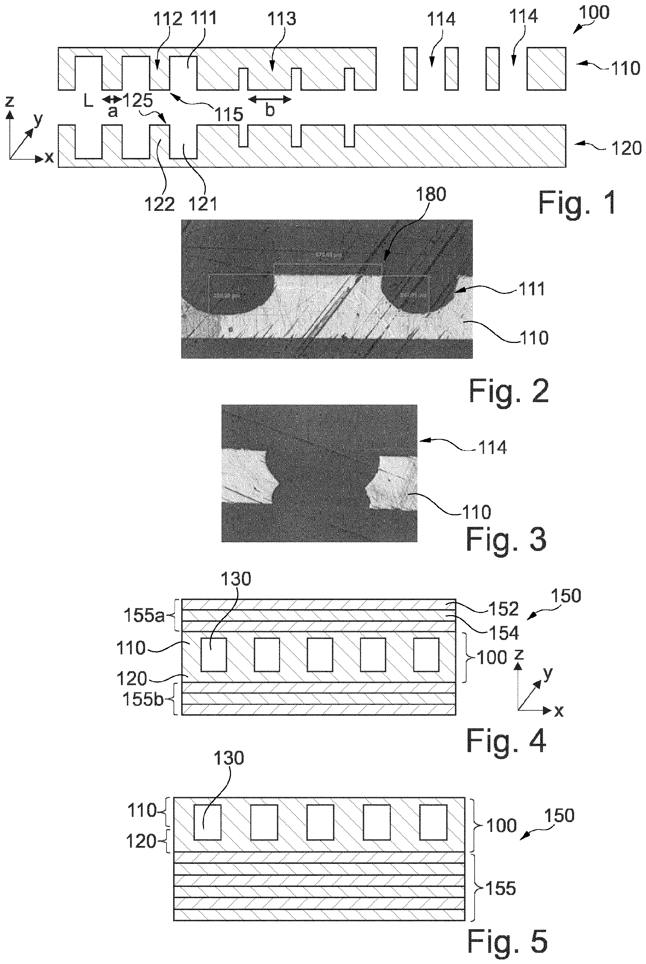

In an embodiment, the common recess has at least one rounded portion (see e.g. Figures 2, 3). Depending on the desired application, an irregular and/or rounded portion may be preferable, depending on the subtractive process that better fits in the manufacturing of the metal structure. A round portion may reflect the advantageous manufacture process by etching which may rather lead to a round than a different shape (in particular at the bottom of the respective recess).

In an embodiment, the first recess and/or the second recess comprises the rounded portion. In other words, the rounded portion may be obtained to one of the recesses or both. For example, the first recess may be formed by another process as the second recess. In this example, one recess may comprise a rounded portion, while the other recess may not comprise a rounded portion. Depending on the desired application, a high design flexibility can be provided.

In an embodiment, the width of the (first/second) recesses between the two (first/second) boundary profiles are smaller (or equal or larger) than the width of an intermediate portion of the common recess (in particular when viewed along the stacking direction). In other words, the intermediate portion of the common recess may be larger (comprises a larger width/diameter) than the sidewalls/bottom of the first recess and/or the second recess. This structural feature may reflect the advantageous manufacture by etching, e.g. producing rounded or broader portions deeper in the respective metal layer structure, and generating narrower portions around the surface of the metal layer structure.

In an embodiment, metal material structures (in particular walls between planarly adjacent recesses) may comprise a smaller (or equal or larger) width (in the horizontal direction) than the (common) recesses defined between the metal material structures. The distance (recess) between walls/pillars and their height may be dependent on the wavelength. The metal material structure may act as a shielding structure to hinder electromagnetic waves from escaping, thereby reducing losses.

In an embodiment, the first external boundary profile and/or the second external boundary profile define(s) an undercut (structure) of the metal structure (in particular along the stacking direction). Such an undercut may be formed for example at an interface between a bottom portion and a sidewall portion of a recess. Further, such an undercut may be formed at an interface between the sidewall portion of a recess and the (main) surface of the respective metal layer structure (in other words: the edge of the recess) (see e.g. Figure 2). The term "undercut" may in particular refer to the circumstance that, in the stacking direction and along the profile of the recess, a small cut-out/indentation is present. The undercut may be a typical relict from an etching process, which may be especially advantageous to form the recesses in the metal layer structure.

In an embodiment, the first external boundary profile and/or the second external boundary profile has a convex/concave extension along the thickness (direction, e.g. ZX or ZY). In an embodiment, the first external boundary profile and/or the second external boundary profile is rounded and/or slanted externally. In an embodiment, the convex/concave shape may mechanically stabilize the metal structure. Additionally, the convex/concave shape may reduce the RF signal propagation losses.

In an embodiment, the common recess has an irregular profile, in particular along the planar direction (horizontal plane) and/or the stacking direction. Depending on the manufacture process (and/or the desired application), the profile of the common recess may comprise irregular structures that may be produced during the described advantageous etching process.

In an embodiment, the first recess and/or the second recess extends along a linear direction (L), wherein the deviation (along the linear extension) of the first external boundary profile and/or the second external boundary profile of the respective recess or the deviation (along the linear extension) between the distance of the respective first external boundary profile and the second external boundary profile is 100 µm or lower, in particular 50 µm or lower, in particular in the range 5 to 100 µm, more in particular in a range 5 to 50 µm. The described circumstance may be related to the impreciseness of a single boundary line (e.g. not following (perfectly) the above described linear extension, due to the intrinsic impreciseness of the erosion, in particular etching erosion). Additionally or alternatively, the described circumstance may be related to two boundary lines belonging to the same metal layer structure. Said boundary lines may refer to the surfaces of the metal material structures (pillars, walls) that define a recess in between.

In an embodiment, the first recess and the second recess face each other, so that they define the common recess as a mirror half shape. In other words, the first recess may be a mirror image of the second recess (and the other way around). Thus, both recesses may have (essentially) the same shape. In an example, both recesses may comprise a rounded portion, so that the resulting common recess would comprise a rounded (e.g. circular) shape. In another example, both recesses comprise an irregular shape, so that the resulting common recess would comprise an irregular shape. Thereby, a highly symmetrical common recess may be provided, which may be advantageous e.g. for an application of the common recess as a waveguide. Moreover, said mirror half shape can be the footprint of the usage of the same process to form the recesses on both metal layer structures, thereby streamlining the manufacturing process in a cheap way.

In an embodiment, the misalignment along the stacking direction of the metal structure comprises an edge, in particular a sharp edge, structure, exposed inside the common recess. For example, a part of the metal material structure (that separates neighboring recesses from each other), may extend into the common recess. Said part may be in particular the edge structure of the recess. The sharp edge may interact with RF signals when applied to the common recess and thus may ensure reliable signal propagation having low, in particular no, signal losses.

In an embodiment, the edge extends at least partially along the planar extension (horizontal plane X, Y). In an embodiment, the edge corresponds to only one portion of the first external boundary profile and/or the second external boundary profile (in particular belongs to metal material structure). Such a misalignment may be due to the fact that both recesses do have not exactly the same shape. Such a defect may be typical for an etching step used to from the recesses.

In an embodiment, the metal structure further comprises a further first recess in the first metal layer structure and/or a further second recess in the second metal layer structure. The first metal layer structure may comprise a plurality of first recesses and/or the second metal layer structure may comprise a plurality of second recesses. Hereby, the first recesses may be (essentially) identical and/or the second recesses may be (essentially) identical. Alternatively, the first recesses have a deviation from the second recesses in width and/or length and/or depth smaller than 50 µm, in particular smaller than 25 µm, and/or 10% relative to each other.

The term "further recess" may refer in this context to a further first/second recess that is different from the first/second recess, for example in shape, size, depth, width, etc. Alternatively, the term "further recess" may refer in this context to a further first/second recess that is equal/different to the first/second recess, for example in shape, size, depth, width, etc., in particular different only by the tolerances resulting from the used manufacturing method. Providing different recesses (and accordingly different common recesses) may enable a high design flexibility and/or combination of different applications within one device.

In an embodiment, the first recess and the further first recess at least partially have a common planar extension, in particular are parallel. In an embodiment, the second recess and the further second recess at least partially have a common planar extension, in particular are parallel. In an embodiment, the first recess and the further first recess have at least partially a common vertical extension, in particular are parallel. In an embodiment, the second recess and the further second recess at least partially have a common vertical extension, in particular are parallel. Thereby, the manufacture may be straightforward, and the reliability may be increased. Additionally and/or alternatively, parallel horizontally and/or vertically aligned recesses may enable creating a common recess in a precise manner.

In an embodiment, the first recess and the further first recess have a different or comparable/similar shape/size. In an embodiment, the second recess and the further second recess have a different or comparable/similar shape/size. Preferably, the difference(s) in terms of dimensions and/or shapes are affected and/or are directly derivable, by the tolerances reachable by the used manufacturing method to form said recesses. This may increase the flexibility of forming recesses having defined shapes using the described method.

In an embodiment, the common recess defines a fluid-tight channel. Thus, a fluid may be accommodated in the common recess in a reliable manner for different advantageous applications. Preferably, tightness of the channel is imparted by a suitable adhesive element between the first metal structure and the second metal structure, at least at the periphery first and the second external boundary profiles.

Additionally or alternatively, the tightness of the channel is imparted by the bonding and / or the welding of the first metal structure with the second metal structure, at least at the periphery first and the second external boundary profiles. In an example, the fluid may be gaseous, in particular air. In this configuration, the channel may be used as an (air filled) waveguide. In a further example, the fluid may be gaseous/liquid and may be used for a cooling/heat transfer purpose. In an embodiment, at least one common recess (channel) may be used for an RF functionality (e.g. antenna waveguide), while at least one further recess (channel) (of the same metal structure) may be used for a non-RF functionality (e.g. as a cooling structure). This may bring the advantage, that the common recess may be used for various reasons and/or applications, e.g. thermal management and/or electromagnetic wave transmission.

In an embodiment, a common recess may be configured for heat transmission, whereas another common recess may be configured for electromagnetic wave transmission (both being located in the same metal structure). This may increase the functionality of the metal structure and/or save space inside the component carrier since two functions may be provided within one constituent.

In an embodiment, the first metal layer structure and the second metal layer structure are directly connected one to each other (with or without a bonding material in between). This may provide the advantage that a thin metal structure can be formed without further intermediate connection structures/layers). The metal layer structures may be connected/attached to each other by established technologies in the component carrier manufacture, for example diffusion bonding, welding, nano-wires, sinter paste, solder, resin sheets, thermal interface materials, etc. In an embodiment, the connection may be realized with a thin low Dk/Df resin sheet. For thermal connection of the layers, sinter-pastes or thermal prepregs may be preferable.

In an embodiment, the first metal layer structure and the second metal layer structure are connected by a bonding material. Such a metal structure may be considered as directly connected. Examples for bonding materials may include a solder material, a sinter material, nanowires, a glue, a welding material. Thus, established and reliable techniques may be directly applied to provide a robust and thin metal structure.

In an embodiment, the first metal layer structure and the second metal layer structure are indirectly connected one to each other by at least one intermediate layer, in particular an electrically insulating layer (structure). Such an intermediate layer may add stability and/or additional functionality, thereby increasing the design flexibility.

In an embodiment, the at least one intermediate layer is sandwiched between the first metal layer structure and the second metal layer structure. In an embodiment, the at least one intermediate layer comprises an electrically conductive layer structure and/or an electrically insulating layer structure.

In an embodiment, the at least one intermediate layer defines a strip (and/or transmission line; optical coupling structures) inside the common recess. In an embodiment, the at least one intermediate layer is at least partially configured as an antenna. This may provide the advantage that the intermediate layer may at the one hand interconnect the metal layer structures efficient, and at the other hand add a further functionality. For example, the intermediate layer (structure) may serve as at least part of an antenna to emit/receive an RF signal in/from the common recess. In other words, the intermediate layer may be used as an emitter/receiver (transmission/emission or receiver structure) for the RF signal transmitted through the common recess channel/waveguide. In an example, the intermediate layer is configured as a copper trace that provides/receives RF signals.

In an embodiment, the metal structure further comprises: a component, arranged on the at least one intermediate layer (in the common recess). In a specific embodiment, the intermediate layer (with the component) is configured as a suspended antenna strip-line. The component may be for example an RF component, in particular a HF (high frequency) component, configured to trigger an RF functionality in/into the common recess. Component embedding may hence be done in a straightforward and easy manner. For example, the component is arranged at the intermediate layer and placed between the metal layer structures. In another example, the component is arranged at the intermediate layer, when coupled to one of the metal layer structures, and before adding the other metal layer structure.

In an embodiment, the intermediate layer comprises an electrically insulating layer structure, wherein conductive interconnections extend through said electrically insulating layer structure, and wherein the conductive interconnections connect the first metal layer structure and the second metal layer structure (thermally and/or electrically). This may provide the advantage that an interconnection between the metal layer structures (through the intermediate layer) can be provided in a cost-effective manner. The interconnection may be used to transfer electric current and or heat between the metal layer structures, e.g. to a heat sink. In an example, the conductive interconnections may have a shape or a conductive via, or having straight sidewalls, for example a cylinder, or may have a shape having tapered sidewalls, for example a cone. In a further example, the conductive interconnection(s) may comprise metal, in particular metal, and/or may comprise a paste.

In an embodiment, at least one first metal layer structure and/or at least one second metal layer structure comprises a blind recess (blind hole) or a through recess (through hole). As can be seen e.g. in Figure 1, a metal layer structure can comprise blind recesses and/or through recesses. Through recesses may provide specific advantages, e.g. an RF functionality outside of a common recess channel. As is shown in Figure 6 for example, a blind hole and a through hole can be connected, thereby providing a common recess with an opening (e.g. a slot) to the outside/environment of the metal structure. Such an opening can be applied e.g. for a slot antenna.

In an embodiment, the through recess extends along one direction along the stacking direction, in particular along a straight direction (see e.g. Figure 1). In an embodiment, the through recess extends along two different directions along the stacking direction. A through hole may be formed in different ways, for example by etching completely through the metal layer structure. Yet, in another embodiment, a through hole may be formed by etching in a first step a first main surface of the metal layer structure and by etching in a second step a second main surface (preferably opposed to the first main surface) of the metal layer structure. In other words, material is removed from both (opposing) sides of the metal layer structure. In an embodiment, one material removal step is done by etching, while the other material removal step is done by the same method (etching) or another method, e.g. one of plasma etching, drilling, routing, etc.

When forming a through recess from both sides of the metal layer structure, the two (or more) portions may have different dimensions (e.g. shape, size, etc.). In particular one portions may be larger/deeper than the other portion (see e.g. Figure 3) (i.e. asymmetric).

In an embodiment, the through recess comprises an hour-glass (like) shape. In an embodiment, the through recess comprises an asymmetric shape. This may provide the advantage that an efficient material removal from both sides may be done by etching. An asymmetry may be advantageous for specific applications. Such an asymmetric structure may comprise two etched portions on top of each other with a protrusion (e.g. a sharp edge) in between.

In an embodiment, the common recess (is configured to) encloses a fluid, for example gaseous (in particular air), or liquid (in particular a heating exchanging medium). A fluid-filled recess may be efficiently be used as a channel, e.g. an air-filled waveguide. In a further embodiment, a least one (common) recess may be filled by a (heat exchange) liquid to transfer heat, thereby preventing overheating.

In an embodiment, the common recess encloses (is at least partially filled by) a solid filler material, in particular a low DK material. Thereby, an RF (antenna) functionality may be enhanced.

In an embodiment, the first metal layer structure and the second metal layer structure have a different thickness one to each one, in particular a difference of 50 µm or more. Such an asymmetric structure may have different advantageous applications, e.g. one thick layer may be sufficient for stabilization, so that material of the other layer can be saved. Alternatively, the first metal layer structure and the second metal layer structure can have the same thickness.

In an embodiment, the metal layer structure has a thickness larger than 30 µm, in particular larger than 50 µm, in particular larger than 300 µm. Hence, a thin metal structure may be provided that can be applied to component carriers and/or antenna structures in an easy, cost-efficient, and space saving (thus flexible) manner. For thin foils, a carrier may be used for the etching process.

In an embodiment, the (first/second) metal layer structure may comprise a surface finish, for example gold or ENIG/ENEPIG.

Furthermore, the surface finish may be an inorganic material, e.g. a glass structure (or a ceramic material). The surface finish may comprise at least one glass barrier layer. The at least one glass barrier layer may comprise two main surfaces, wherein the two main surfaces comprise a different adhesion property (for example a different surface tension (property)) (with respect to each other).

In an embodiment, the two main surfaces of the at least one glass barrier layer comprises hydrophilic properties, and/or the other one of the two main surfaces of the at least one glass barrier layer comprises hydrophilic properties or hydrophobic properties.

In the context of the present document, the term "glass barrier layer" may in particular refer to a layer (structure) that comprises glass material and is, at the same time, suitable to fulfill a barrier function, in particular regarding the migration of chemical species. In this context, the term "glass" may in particular refer to a non-crystalline and amorphous solid. In a preferred example, the glass comprises silicate, in particular silicon dioxide (SiO₂). In a further example, the glass comprises at least one silane and/or siloxane compound. In yet another example, the glass may comprise functional groups, e.g. hydrophilic and/or hydrophobic functional groups, in particular at the main surfaces. Since the glass barrier layer is a (continuous or discontinuous) layer, it comprises two main surfaces opposite to each other. Hereby, the two main surfaces can be different in at least one physical/chemical property, specifically regarding their surface tension (surface energy).

Further, high frequency signal application and/or fine line applications may be significantly improved by the described approach, in particular because smooth metal surfaces can be applied. Additionally, adhesion promoting processes, e.g. bond-film process for inner layers, may be replaced as well as micro-etching processes for outer layers.

In an embodiment, etching (or laser erosion) is done from top and bottom (simultaneously). In an embodiment, the velocity of the foil, while passing through the etching apparatus, is adjusted to the recess depth (quickly going through the etching apparatus means less depth). In an embodiment, a photoresist determines etching compensation. In an embodiment, the process chemistry (specially additives) determine under-etch (structural feature).

In a specific embodiment, the disclosure may refer to at least one of the following aspects: i) etching of bare copper foils yielding copper pillars/walls with different but controlled depth profile, ii) through holes can be obtained, iii) using copper structures solely without prepreg allows for manufacturing of fully shielded structures capable of transmitting RF signals (not DC applied), iv) miniaturized 3D waveguide antennas can be obtained with decreased z-height, v) antenna can be used for thermal management (waveguides are less sensitive to temperature changes), vi) for RF front end antennas limited to (waveguide) antennas, the disclosure can be used for cooling purposes as well.

In the context of the present application, the term "antenna" may particularly denote an arrangement of metallic conductor elements electrically connected for instance through a transmission line to a receiver or transmitter. Hence, an antenna may be denoted as an electrical member which converts electric power into radio waves, and/or *vice versa.* An antenna may be used with a controller (for instance a control chip) such as a radio transmitter and/or radio receiver. In transmission, a radio transmitter may supply an electric current oscillating at radio frequency (i.e. a high frequency alternating current) to the antenna 's terminals, and the antenna may radiate the energy from the current as electromagnetic waves (in particular radio waves). In a reception mode, an antenna may intercept some of the power of an electromagnetic wave in order to produce a tiny voltage at its terminals, that may be applied for example to a receiver to be amplified. In embodiments, the antenna may be configured as a receiver antenna, a transmitter antenna, or as a transceiver (i.e. transmitter and receiver) antenna. In an embodiment, the antenna may be used for a radar application. The antenna may, for example, comprise a dipole antenna, a folded dipole antenna, a ring antenna, a rectangular loop antenna, a patch antenna, or a coplanar antenna. The antenna may also comprise a yagi antenna or a fractal antenna. A yagi antenna may be a multi-beam directional antenna for so-called mm wave applications. A fractal antenna may be another type of antenna that uses a self-similar design to maximize the length of a material in a total surface area. A fractal antenna may be compact and wideband and can act as an antenna for many different frequencies.

In the context of the present document, the term "radar" may refer to an object-detection that uses electromagnetic waves to determine the range, angle, or velocity of one or more objects. A radar arrangement may comprise a transmitter transmitting electromagnetic waves (e.g. in the radio or microwave range). The electromagnetic waves from the transmitter reflect off the object and return to a receiver. Hereby, one antenna may be used for transmitting and receiving. Furthermore, a processor such as an electronic component may be used to determine properties of the object such as location and speed based on the received electromagnetic waves.

In an embodiment, the stack is coupled (interconnected) with (the upper main surface of) the metal structure through an intermediate layer structure. The intermediate layer structure can be an electrically insulating structure, for example low flow prepreg and/or low Dk/Df material. Between exposed electric connections of the stack and the metal structure, there may be arranged solder balls (BGA) and/or further interconnection structures, for example sinter paste (may be any metal paste), conductive paste, nanowires, or a thermal prepreg. The connection structures through the intermediate layer structure can be (partially) applied for the RF signal and/or (partially) (or fully) applied as cooling channels. In this embodiment, the metal structure may be used as a heatsink (in addition to the RF signal functionality; thermal path and signal path). In an embodiment, the intermediate layer structure is realized without (inter) connection structures, but for example as a conductive paste or nanowires.

According to an aspect of the invention, there is described an antenna assembly comprising:
i) a (multilayer) stack (e.g. a component carrier such as a printed circuit board) comprising:
   ia) at least one electrically conductive layer structure (e.g. copper traces) and at least one electrically insulating layer structure (e.g. a resin layer), wherein at least a portion of said electrically conductive layer structure (e.g. an exposed copper pad/trace) is provided at the external side of the stack (in particular exposed) and is configured to act at least as part of an electromagnetic wave coupling structure (in particular a launcher); and
   ib) a component (e.g. an RFIC), at least partially embedded in the stack, and coupled to said electromagnetic wave coupling structure (e.g. via a redistribution layer structure); and
ii) an antenna structure (e.g. a block or a layer stack), comprising an opening to a channel (in particular a wave guide) passing through the antenna structure (e.g. from a first main surface to an opposed second main surface).

Hereby, the stack and the antenna structure are connected (e.g. via electric connections such as solder balls), so that the electromagnetic wave coupling structure and the opening to the channel face each other (and electromagnetic waves from the electromagnetic wave coupling structure can be directly coupled into said opening/channel).

In the present context, the term "electromagnetic wave coupling structure" may refer to a structure suitable to couple an electromagnetic wave (e.g. an RF signal) into a further structure, preferably an opening to a channel (such as a waveguide) of an antenna structure. In an embodiment, the electromagnetic wave coupling structure can be configured as a conductive layer structure, e.g. a pad or pillar comprising a metal, in particular copper, silver or gold. Additionally or alternatively, the electromagnetic wave coupling structure may comprise electrically insulating material, for example organic polymeric material, having a dielectric constant smaller than 7, in particular smaller than 4. In a first embodiment, the electromagnetic wave coupling structure is configured as (a part of) an electrically conductive layer structure of the stack (in particular an external/outermost layer). In a second embodiment, the electromagnetic wave coupling structure can be configured as a surface finish (e.g. ENEPIG). In a preferred example, the surface finish may be Nickel-free (Ni-free may increase the performance). The electromagnetic wave coupling structure can have a comparable or smaller size (or larger size) (diameter) than the corresponding opening/channel. In an embodiment, the size may be in line with the waveguide entrance, e.g. the same. In an example, the launcher may be dependent from the square-root of Dk (e.g. if Dk is four, the launcher shows a size of half of the waveguides cross section).

Preferably, the coating of the side walls of the channel may be electrically conductive. Electrically conductive coating material may comprise a metal, e.g. copper or silver, which may bring the advantage of lower losses of electromagnetic waves when passing through the channel. Alternatively, the coating may comprise electrically insulating material. The antenna structure may be further configured to serve as a mounting structure for a (component carrier) stack. In an embodiment, the antenna structure comprises a plurality of said openings/channels (in the horizontal direction) next to each other. These channels may be separated from each other or (at least partially) interconnected.

In the present context, the term "face each other" may refer to the orientation/alignment of the stack and the antenna structure with respect to each other. In particular, said term may refer to the orientation/alignment of the electromagnetic waves coupling structure and the opening (to the channel) with respect to each other. In a first embodiment, the opening and the electromagnetic waves coupling structure each have a center point/geometrical barycenter one aligned with the other along the stack thickness direction (vertical direction Z). A deviating tolerance may hereby be smaller than 20 µm. A misalignment may be dependent on the applied frequency. In conventional examples, the misalignment may be 50 µm or more (at a frequency of e.g. 77 GHz). Coupling structure can be, for example, patch-like, dipole-like, slot-like etc. In a second embodiment, the opening and the electromagnetic waves coupling structure may each define an external planar surface, wherein said respective surfaces (at least partially) overlap (completely or partially) one to each other. Furthermore, the bottom side of the component carrier may be oriented towards the top side of the antenna structure.

According to an exemplary embodiment, a component carrier based antenna assembly can be provided in an efficient, reliable, and compact manner, when a component carrier stack is mounted on an antenna structure. The stack comprises hereby an embedded component (preferably the RF component and/or a monolithic microwave integrated circuit (MMIC)) and an electrically conductive layer structure (connected to said embedded component) that at least partially forms an electromagnetic wave (RF signal) coupling structure that may serve as a launcher. The antenna structure comprises an opening to a (through) channel that may serve as the waveguide. Hereby, the stack is arranged on the antenna structure, so that the electromagnetic wave coupling structure faces the corresponding channel opening. In this manner, the RF signal emitted by the electromagnetic wave coupling structure may be directly fed into the channel of the antenna structure.

In comparison to conventional solutions (see e.g. Figure 2), two elements (stack and antenna structure) are sufficient for the RF application, thereby decreasing package size and efforts/costs. Additionally, the RF performance may be highly improved.

In an embodiment, the component carrier stack serves as the package, so that one element (carrier board) can be omitted. The stack comprises a layered build-up which may enable the use of reinforcements such as glass fibers or ceramic fillers, thereby increasing the mechanical reliability (no over mold necessary). More than one component (e.g. RF chip and processor), in particular different components, can be embedded in the stack (e.g. side-by-side) to increase the amount of RF channels and/or launchers, thereby enabling new interesting applications. The stack surface may further serve as an increased surface area for the application of a plurality of launcher structures, allowing for the manufacturing/ developing of scalable systems.

Furthermore, the antenna structure may be provided such that there is no shift/misalignment due to production tolerances in the waveguide channel (which leads to additional losses). In an example, such a shift-free channel may be provided by a metal structure channel.
In an embodiment, the channel vertically extends through the (entire) antenna structure. This may provide the advantage that the channel may be used to guide the emitted electromagnetic wave (from the coupling structure) directly to a specific application, e.g. a radar application. In a basic embodiment, the channel may be a straight opening (e.g. like a through-hole). In a further embodiment, the channel may comprise a more sophisticated shape through the antenna structure, e.g. an L-shape (see Figure 1) or a T-shape. The sidewalls of the channel may be partially or fully metallized and/or coated. In an example, the routing of channels insight the antenna structure can be done in different ways, preferably for implementing many channels on a small area. In an example, a short channel path may be preferred.

In an embodiment, the extremity of the channel (at the lower main surface of the antenna structure), opposed to the opening faced to the electromagnetic wave coupling structure, comprises an opening structure (in particular a slot), configured as a (electromagnetic) wave emitter or a (electromagnetic) wave receiver. This may provide the advantage that the electromagnetic wave can be efficiently guided to/from a specific application, by passing directly from the opening through the channel and exit the antenna structure at the opposing end of the channel (or the other way around). Said opposing end may comprise one or more slots (e.g. two slots in Figure 1) which may serve to emit and/or receive electromagnetic waves. Such an architecture may be suitable for radar applications, in particular when a plurality of openings are arranged next to each other.

In an embodiment, the extremity of the channel, opposed to the opening faced to the electromagnetic wave coupling structure, comprises an electrically conductive coupling layer structure comprising at least one aperture being in communication with the opening of the antenna structure. In this manner, the signal quality/performance may be improved. In the present context, the terms "opening" and "aperture" may refer to the same structure or to different structures. Specifically, an opening may be any opening at the extremity of the channel, while the aperture may refer to an opening in said electrically conductive coupling layer structure. The electrically conductive coupling layer structure may form part of the metallization of the channel walls. Yet, the electrically conductive coupling layer structure may also be an additional structure, e.g. provided by plating. The metallization may improve the electromagnetic wave transmission.

In an embodiment, the internal walls (sidewalls) of the at least opening (and/or aperture) on the antenna structure and/or the channel are coated by an electrically conductive material (or paramagnetic material), in particular a metal. In an embodiment, the internal walls of the at least opening (and/or aperture) on the antenna structure and/or the channel are coated by a material having a magnetic permeability in the range from 10⁻⁶ H/m to 10⁻⁵ H/m, preferably between 1.1*10⁻⁶ and 5*10⁻⁶. Thereby, the RF signal transmission quality/performance may be significantly improved.

In an embodiment, the antenna structure comprises a further stack comprising at least one further electrically conductive layer structure and at least one further electrically insulating layer structure. In this example, the antenna structure is also configured as a component carrier with a multilayer stack. This may provide the advantage that both, the stack and the further stack, can be manufactured in the same facility with similar/comparable materials and process steps, thereby saving costs/efforts. The build-up structure of such a stack may be suitable to embed components (to increase functionality) and/or reinforcement structures (to increase stability).

In an embodiment, the at least one further electrically conductive layer structure comprises the electrically conductive coupling layer structure. Thereby, the electrically conductive coupling layer structure (with the aperture) may be provided together with the further stack (essentially) without additional process steps.

In an embodiment, an antenna is located at least partially inside the further stack and/or on an external side of the further stack (in particular at the opposed side compared with the opening). Thereby, the functionality may be further increased. The antenna may be embedded in the further stack or surface-mounted to said further stack. In an embodiment, the antenna may be coupled to the channel (e.g. by a transmission line/stripline). In another embodiment, the antenna may be arranged at the surface of the antenna structure side-by-side to the openings (opposed to the stack), for example the aperture and/or the slot. The antenna may be configured e.g. as a patch antenna, a slot antenna, or a horn antenna.

In an embodiment, the channel defines a waveguide. In an embodiment, the channel defines an antenna wave emitter or wave receiver. The antenna can be configured as a slot antenna or as a patch antenna. Thus, the channel may yield an efficient, compact, and reliable waveguide application.

In an embodiment, the waveguide is in direct physical and/or electromagnetic connection with the antenna. This may provide the advantage that the functionality and/or the design flexibility is highly improved. The (embedded or surface-mounted) antenna may be used to emit/receive the electromagnetic waves into/from said waveguide through a direct (physical) or indirect (electromagnetic connection).

In an embodiment, a portion of the opening/channel of the antenna structure is configured as the waveguide and a further portion of the opening/channel is configured as the antenna wave emitter or wave receiver. In an example, the channel may comprise a specific shape with different portions, which are configured for different tasks. In another example, a plurality of openings may be provided and dedicated to different tasks, e.g. emitting, transmitting, and receiving. Thereby, efficiency and reliability may be improved.

In an embodiment, the electromagnetic wave coupling structure comprises a launcher structure configured for transmitting electromagnetic waves from the stack to the antenna structure (and/or the other way around). Specifically, electromagnetic waves are transmitted from the launcher (in) to the channel. As described above, a launcher may be seen as an element suitable to feed electromagnetic waves (RF signals) into an opening/channel, in particular a waveguide. The electromagnetic wave coupling structure (preferably formed as an electrically conductive layer structure during stack manufacture) may be configured as such a launcher, essentially without further costs/efforts.

In an embodiment, the launcher comprises a conductive layer structure. In an embodiment, the conductive layer structure is provided on/in a second electrically insulating layer structure of the stack, wherein the second electrically insulating layer structure comprises a material and/or a constituent different from that of the at least one electrically insulating layer structure. In an embodiment, the second electrically insulating layer structure comprises a high frequency material (for example Meg8, Isola, ABF GL), in particular a low Dk/Df material. In an embodiment, the second electrically insulating layer structure is free from a covering structure, in particular free from a surface finish and/or solder resist.

This may provide the advantage that the electromagnetic wave coupling structure/launcher/conductive layer structure is coupled to/arranged on/arranged in an electrically insulating layer structure that comprises a specific material suitable for RF/HF applications. Hence, the signal transmission quality/performance may be highly increased. For example, a material with a low Dk/Df may be applied.

In an embodiment, the launcher planar extension (in the horizontal plane) (or the width/diameter) is smaller (or equal or larger) than the planar extension of the opening/channel (in particular the waveguide) of the antenna structure. This may provide the advantage that the RF signals can be fed into the channel/waveguide in a highly accurate manner.

In an embodiment, the launcher is directly facing the waveguide (without a further structure/element in between). This may enable most efficient signal transmission.

In an embodiment, the size auf the launcher is larger than the size of a pad of the electrically conductive layer structure. Thereby, leakage may be suppressed. For example, the minimum required pad length/distance may be smaller than 450 µm for 77 GHz. In an example, the distance to suppress the leakage wave may be calculated as a function of dielectric material Dk filling the pad and frequency.

In an embodiment, the central point/portion/part of the launcher is misaligned with the central point(portion/part of the respective (air) channel. With the described approach, such a misalignment may be efficiently compensated. For a typical patch antenna-like structure used for a launcher, the misalignment tolerance may be relaxed as the patch dimension is quite large. In a specific example, the patch size in an IC-substrate would be around 1.0 x 1.5 mm and 10% of misalignment may be acceptable, then up to 100 µm in x-axis and 150 µm in y-axis misalignment would be a reasonable value.

In an embodiment, the launcher comprises at least a portion of the at least one electrically conductive layer structure (see above).

In an embodiment, the (air) channel (vertical waveguide) may be typically either rectangular or elliptical. Depending on that, the launcher could be modified as well due to the electrical/magnetic field polarization (mode-matching). A typical design for a launcher may be: rectangular patch, slot, dipole, monopole (basically typical structures used for PCB antennas).

In an embodiment, the launcher comprises an external protection structure, in particular a surface finish (for example ENIG or ENEPIG). In an example, the external protection structure is Nickel-free, thereby eventually increasing the performance. As described above, the launcher may be formed by a conductive layer structure, e.g. an electrically conductive layer structure of the layer stack. Yet, the launcher may also be formed by a (electrically conductive) surface finish. Also in this embodiment, the formation of the launcher may be directly integrated in the stack manufacture, (essentially) without additional costs/efforts.

In an embodiment, the electromagnetic waves coupling structure is connected with the embedded component only with the electrically conductive layer structures of the stack. In an embodiment, said electrically conductive layer structures are solder material-free. In an embodiment, the connection is composed of vias and traces/pads only. In a preferred embodiment, said electric connection between embedded component and electromagnetic waves coupling structure is realized by a redistribution layer (structure). Such a RDL may be common in the field of layer build-ups and may serve to translate small contacts of the component to large contacts at the surface (e.g. solder balls). Accordingly, the component may be efficiently connected (without additional effort) to surface electric contacts and/or the electromagnetic waves coupling structure.

In an embodiment, the electromagnetic wave coupling structure comprises an external layer structure of a material not affecting the electromagnetic waves, in particular a hydrophobic material. Thereby, an efficient protection (e.g. against copper migration) may be provided without affecting the signal transmission quality.

Said external layer structure may be configured as a hydrophobic protection film. In the context of the present document, the term "hydrophobic protection film" (or hydrophobic protection layer or hydrophobic protection ink or hydrophobic protection coating) may particularly denote a thin layer (film-like layer structure) of material that comprises hydrophobic properties. In an embodiment, a hydrophobic protection film may be provided onto a surface of an electrically conductive layer structure and/or an electrically insulating layer structure, hereby serving as a protection layer. For example, a metal layer may be protected from corrosion using the hydrophobic protection film, since water and other fluids/liquids may be kept away due the hydrophobic properties. In another example, an electrically insulating material, for example an (organic) polymer, may be protected from decomposition (e.g. dissolution or swelling) using the hydrophobic protection film, since water and/or polar organic solvents may be kept away due to the hydrophobic properties. In another embodiment, the hydrophobic protection film may cover an opening, for example an access hole to the cavity. Thereby, the inside of the cavity may be protected against fluid (in particular liquid) from the outside. Yet, the hydrophobic protection film may be permeable for gas and/or electromagnetic waves and/or sonic waves, thereby enabling at the same time a protection function and a technical application function. In a further embodiment, the hydrophobic protection film may be formed inside of an opening, e.g. fill said opening as a hydrophobic protection (filling) material. Yet, the hydrophobic protection film may be electrically insulating.

The hydrophobic protection film may comprise organic material and/or inorganic (layer structure) material (e.g. glass).

In one example, a mixture of components such as a toughening resin, a flexibilizing hardener, a basic hardener, a defoamer, a functional filler, and a crosslinking agent may be used (polymer, organic hydrophobic protection film).

In another example, the hydrophobic protection film may comprise an inorganic material, e.g. glass (in particular silicon dioxide). In an example, the hydrophobic protection film may comprise two main surfaces, wherein the two main surfaces comprise a different adhesion property (e.g. hydrophobic and hydrophilic).

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS₂, CuGaOz, AgAlO₂, LiGaTe₂, AgInSe₂, CuFeS₂, BeO.

In this context, the term "glass" may in particular refer to a non-crystalline and amorphous solid. In a preferred example, the glass comprises silicate, in particular silicon dioxide (SiO₂). In a further example, the glass comprises at least one silane and/or siloxane compound. In yet another example, the glass may comprise functional groups, e.g. hydrophilic and/or hydrophobic functional groups, in particular at the main surfaces. Since the glass layer is a (continuous or discontinuous) layer, it comprises two main surfaces opposite to each other. Hereby, the two main surfaces can be different in at least one physical/chemical property, specifically regarding their surface tension (surface energy).

In an embodiment, the electromagnetic wave coupling structure is provided at the external main surface of the stack. In an embodiment, the electromagnetic wave coupling structure is provided in a recess, in particular in an opening at the external main surface of the stack. Depending on the desired application, one of these options may be preferable. While a recess may provide additional protection, an external main surface may lead to better signal transmission.

In an embodiment, the launcher structure can be arranged at the bottom of a cavity, in particular wherein the cavity walls are shieled (e.g. a 2.5D^{™} cavity). This may additionally physical protect the launcher structure.

In an embodiment, the stack is directly connected with the antenna structure. In an embodiment, connected by at least one of an adhesive, a solder material, a through solder structure, a connecting element, in particular a nanowire or a pillar, or a sinter structure. Thus, both structures can be (electrically) interconnected in a robust manner using established and reliable measures.

In an embodiment, sinter paste and/or conductive paste (e.g. z-interconnection paste (Ormet paste)) may be applied (see e.g. Figure 20). This may provide the advantages that a conductive paste can be used as shielding structure surrounding the launcher structures. In addition, the distance between antenna and launcher may be further reduced, thereby limiting signal losses.

In an embodiment, the stack is connected with the antenna structure at a (first) distance, in particular wherein said (vertical) distance between stack and antenna structure is smaller than 200 µm, in particular smaller than 100 µm. This short distance may enable a small/thin module size and/or a highly efficient feed of RF signals in the channel/waveguide.

In an embodiment, the stack and the antenna structure are connected by a connection structure, in particular solder balls (see e.g. Figure 1) (e.g. BGA), conductive paste, sinter connection, nanowires, or an electrically insulating connection (glueing, laminating, etc.). Said connection structure may require more space than only interconnecting the stack and the antenna structure. Yet, the connection structure may render the connection more robust/reliable.

In an embodiment, the antenna structure has a planar extension (in the horizontal direction) greater/larger (or equal or smaller) than that of the stack. This implies that the stack is provided in an especially small and compact design. Further, the antenna structure extension may be larger to provide additional openings/channels, thereby enabling a wider range (e.g. for radar applications).

In an embodiment, the component is fully embedded in the stack. Thereby, optimal protection may be provided.

In an embodiment, the component is located in a vertical (direction) central portion. In an embodiment, the component is embedded in a (central) core layer structure. Such a core layer structure may be thicker than other layers of the stack and/or comprise a specifically robust material such as e.g. fully cured resin (e.g. FR4), metal, glass, or ceramic. Embedding in the core may be efficient and robust (in particular during manufacture). Further, embedding of two or more components (side-by-side) may be preferably realized in a core layer structure.

In an embodiment, a respective build-up layer is located on both opposed main surfaces of the component. In other words, there may be arranged an upper layer build-up on top of the component (and/or the core layer structure) and/or there may be arranged a lower layer build-up at the bottom of the component (and/or the core layer structure). Such a build-up may enable efficient embedding and additional functionalities such as electrical connections to the main surfaces.

In an embodiment, the component comprises electrical connections on both opposed surfaces. Hence, the component may be connected to both main surfaces and/or interconnect said two main surfaces. This may enable further functionalities by connecting the component to further devices.

In an embodiment, a heatsink can be applied on top of the stack, in particular connected to the embedded component. Thereby, thermal management may be improved. In an embodiment, thermal vias/inlays can be used to (further) remove the heat. Further, a signal path may be decoupled from a thermal path.

In an embodiment, a plurality of stacks is connected to one common antenna structure. This embodiment may be advantageous for specific applications (e.g. radar). Two or more stacks (e.g. side-by side, with or without physical contact) may be arranged to a common antenna structure. In this manner, a high number of channels may be established in an easy, flexible, and straightforward manner. A further advantage may be that, if just a single module is broken, it can be exchanged without throwing away the rest of the expensive components.

In an embodiment, the surface of the stack opposite to the surface connected with the antenna structure comprises at least one connecting portion, said at least one connecting portion being configured to be connected to an external component and/or to a further stack. This may highly increase the design flexibility.

In an embodiment, there is described an antenna system, comprising:
i) a common further stack, and ii) one or more antenna assembly/assemblies as described above, mounted on the common further stack. In order to increase the robustness, a plurality of antenna assemblies may be arranged on a common mounting structure, preferably configured as a stack. Thereby, same materials/processes may be applied for the manufacture, thereby saving costs/efforts.

In an embodiment, at least two of the antenna assemblies comprise different features, in particular regarding frequency. Different antenna assemblies on a common further stack may enable a large variety of functionalities, thereby highly increasing the flexibility of applications.
In the context of the present application, the term "antenna" may particularly denote an arrangement of metallic conductor elements electrically connected for instance through a transmission line to a receiver or transmitter. Hence, an antenna may be denoted as an electrical member which converts electric power into radio waves, and/or *vice versa.* An antenna may be used with a controller (for instance a control chip) such as a radio transmitter and/or radio receiver. In transmission, a radio transmitter may supply an electric current oscillating at radio frequency (i.e. a high frequency alternating current) to the antenna 's terminals, and the antenna may radiate the energy from the current as electromagnetic waves (in particular radio waves). In a reception mode, an antenna may intercept some of the power of an electromagnetic wave in order to produce a tiny voltage at its terminals, that may be applied for example to a receiver to be amplified. In embodiments, the antenna may be configured as a receiver antenna, a transmitter antenna, or as a transceiver (i.e. transmitter and receiver) antenna. In an embodiment, the antenna may be used for a radar application. The antenna may, for example, comprise a dipole antenna, a folded dipole antenna, a ring antenna, a rectangular loop antenna, a patch antenna, or a coplanar antenna. The antenna may also comprise a yagi antenna or a fractal antenna. A yagi antenna may be a directional antenna for so-called mm wave applications. A fractal antenna may be another type of antenna that uses a self-similar design to maximize the length of a material in a total surface area. A fractal antenna may be compact and wideband and can act as an antenna for many different frequencies.

In an embodiment, a distance (the air gap) between stack (package) and antenna structure (waveguide antenna) may be in the range 0 to 150 µm (smaller may be better).

In an embodiment, the launcher is configured as a slot or a patch.

In an embodiment, the opening comprises a circular, a rectangular or an elliptical shape.

In an embodiment, a distance between launcher and connection structure (solder ball) is smaller than 400 µm, in particular smaller than 300 µm.

In an embodiment connection structure (solder ball) is configured as
a (electromagnetic) shielding structure for the launcher.

According to an embodiment, the stack is free from a cavity, which is filled with gas and/or a channel, in particular a wave guide. This may bring the advantage of using of the delimited volume of the stack more efficiently, since the cavity or channel may occupy a relatively large volume, for example 10%, of the stack. For this reason, the stack may comprise a high electrically conductive layer structure density, for example copper traces and/or vertically connection structures and the channel is located with another compartment of the antenna assembly, preferably in the antenna structure.

In an embodiment, a ground signal of the stack is electrically coupled with the antenna structure, in particular with a conductive coating of the channel. An electric connection between the stack and the antenna structure may be used only in case an electrical connection is needed (e.g. for grounding the sidewalls of the channel, connecting other components, etc.). Another option would be an electrically insulating connection by glueing, laminating, etc. (or both). Alternative electrical connections may be conductive paste, nano-wires, sintered connections, etc.

In an embodiment, the wave coupling structure (launcher) is located at least partially within a cavity of the stack (see e.g. Figure 5). This may provide the advantage that the RF/HF signal is guided/streamlined before entering the gap between stack and antenna structure (in particular the air channel).

In an embodiment, the antenna assembly comprises a surface-mounted component (e.g. a driver /processor) configured to drive one or more embedded components (e.g. RFICs). This configuration may be related to massive MIMOs (e.g. in imaging Radar and 5G/6G). In an example, the MMIC of a HR radar can be embedded, having the digital and analogue function combined in a single IC.

In an embodiment, the electromagnetic wave coupling structure is shifted/offset with respect to the corresponding channel opening (launcher/waveguide misalignment). The electromagnetic wave coupling structure and the corresponding channel opening still face each other, yet with a certain misalignment. Yet, the described antenna assembly may still allow for an efficient and reliable radio frequency functionality.

In an embodiment, the stack comprises at least one surface-mounted component, in particular at the main surface being opposite to the main surface that faces the antenna structure. Said surface-mounted component can be a further component and/or a heat-removing structure, e.g. a heatsink. In this manner, the stack may be divided in two functionalities: a thermal path (in the upper build-up towards the surface-mounted component), and a signal path (in the lower build-up towards the antenna structure).

In an embodiment, the (exposed) electrically conductive layer structure comprises a surface finish, e.g. the pads of said layer structure are covered by surface finish material. The surface finish comprises e.g. ENIG or ENEPIG. In an embodiment, the electromagnetic wave coupling structure is covered by said surface finish (as well). In an example, at least one launcher comprises an surface finish (being preferably Nickel-free, for example palladium or silver).

In an embodiment, the electromagnetic wave coupling structure is covered by a silicon-comprising protection layer (e.g. a selective SiOx protective coating) exposed on the outer surface. Thereby, efficient protection may be enabled that does not decrease the RF performance.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows a metal structure for a component carrier, according to an exemplary embodiment of the invention.
Figure 2 shows a first metal structure with a first blind recess, according to an exemplary embodiment of the invention.
Figure 3 shows a first metal structure with a first through recess, according to an exemplary embodiment of the invention.
Figure 4 shows a component carrier with an embedded metal structure, according to an exemplary embodiment of the invention.
Figure 5 shows a component carrier with a surface-mounted metal structure, according to an exemplary embodiment of the invention.
Figure 6 shows a component carrier with a surface-mounted metal structure that comprises openings, according to an exemplary embodiment of the invention.
Figure 7 shows a component carrier with a metal structure that comprises an intermediate layer, according to an exemplary embodiment of the invention.
Figure 8 shows an antenna assembly with the metal structure according to an exemplary embodiment of the invention.
Figure 9 shows a component carrier with a stack and a metal structure, according to an exemplary embodiment of the invention.
Figure 10 shows a component carrier with a stack and a metal structure with openings, according to an exemplary embodiment of the invention.
Figure 11 shows a component carrier with a stack, an embedded metal structure, and further components, according to an exemplary embodiment of the invention.
Figure 12 shows a metal structure with three metal layer structures, according to an exemplary embodiment of the invention.
Figures 13A and 13B respectively show a top view on an antenna structure, according to an exemplary embodiment of the invention.
Figure 14 shows a metal structure 100 according to a further exemplary embodiment of the invention.
Figure 15 shows a component carrier with a metal structure that comprises an embedded transmission line as an intermediate layer, according to a further exemplary embodiment of the invention.

### Detailed Description of the Drawings

**Figure 1** shows a metal structure 100 for a component carrier (see e.g. Figures 3 to 7) and/or an antenna assembly (see Figure 8), according to an exemplary embodiment of the invention. It can be seen that the metal structure 100 comprises:
i) a first metal layer structure 110 comprising a first recess 111 exposed to one first surface and defining a first external boundary profile 115, and
ii) a second metal layer structure 120 comprising a second recess 121 exposed to a second surface and defining a second external boundary profile 125.

The recesses 111 and 121 are hereby formed by an etching process, in particular wet chemical etching. Alternatively, the recesses 111 and 121 may be formed by plasma etching and/or laser erosion. While some recesses 111, 121 are configured as blind recesses/holes, other recesses 114 are configured as through recesses/holes. The first recesses 111 are defined between respective first metal material structures (here pillars) 112, while the second recesses 121 are defined between respective second metal material structures (here pillars) 122.

The first metal layer structure 110 and the second metal layer structure 120 are stacked to face each other, so that the first recess 111 and the second recess 121 define a common recess 130. An opening and/or a whole channel (a boundary profile) can be formed by such a common recess 130 of the metal structure 100. Since the metal structure comprise a plurality of common recesses 130 (with different shapes and sizes), a plurality of channels 221 can be provided (side-by-side) in the component carrier/antenna assembly (see Figure 8).

The common recess 130 has an irregular profile along the stacking direction (and along the planar direction/horizontal plane), which can also reflect the manufacture step of etching. The width of the recesses 111, 121 between the two boundary profiles 115, 125 is smaller (alternatively equal or larger) than the width of an intermediate portion of the common recess 130 along the stacking direction. The first recess 111 and the second recess 121 face each other, so that they define the common recess 130 as a mirror half shape (in another words, the first recess and the second recess are mirror images with respect to each other).

Besides the first recess 111, there are further first recesses arranged in parallel to the first recess 111. The same holds true for the second recess 121 and further second recesses. The first/second recess 111, 121 have different shapes (depth, planar extension) in comparison to the further first/second recesses (can be of same size, but do not have to be). Yet, the shapes of corresponding first recesses 111 and second recesses 121 are respectively similar in this example (yet, there may be a deviation).

In an exemplary embodiment, the first metal layer structure 110 and/or the second metal layer structure 120 is larger than 50 µm in the stack thickness direction (Z). Alternatively, the first metal layer structure 110 and/or the second metal layer structure 120 is larger than 100 µm in the stack thickness direction. The thickness of the first metal layer structure 110 and the thickness of the second metal layer structure 120 may be different relative to each other. Alternatively, they may be the same. The thickness of the metal structure 100 may be at least 100 µm, in particular at least 300 µm.

**Figure 2** shows a first metal structure 110 with a first blind recess 111, according to an exemplary embodiment of the invention. In comparison to the example of Figure 1, the first recesses 111 (and accordingly also the common recess 130) has a rounded portion instead of a rectangular portion.

The first external boundary profile 115 defines an undercut 180 of the metal structure 100 along the stacking direction. Said undercut 180 can be seen in Figure 2, where the rounded bottom portion of the recess is in contact with a straight sidewall portion of the recess 111 (at the edge of said recess). The edge portion at the upper main surface of the first metal layer structure 110 extends in the horizontal plane over the sidewall of the first recess 111. The undercut 180 is in this example a relict from the etching process.

The misalignment along the stacking direction of the metal structure 100 comprises an edge structure exposed inside the common recess. Said edge structure can be the same structural element as the undercut 180. The edge structure extends at least partially along the planar extension (X, Y, not seen in this Figure), corresponding to only one portion of the first external boundary profile 115.

**Figure 3** shows a first metal structure 110 with a first through recess 114, according to an exemplary embodiment of the invention. The through recess 114 extends along one direction along straight along the stacking direction Z. Yet, the through recess 114 has been formed by two material removal steps, in particular a first etching step from above and a second etching step from below of the metal layer structure 110. The two steps can also be done at the same time as one step, e.g. by using etching nozzles on top and bottom. As soon as a certain depth is reached, the pressure on the bottom side may be adjusted. The first etching step has been more intense, so that the upper part of the through recess 114 is larger and deeper than the lower part of the through recess 114. The through recess 114 is thus asymmetric and comprises in this example an hour-glass-like shape. The interface of the upper part and the lower part of the through recess 114 can be termed the (sharp) edge structure that can extend in the planar direction. This structure is a relic of the described etching process.

**Figure 4** shows a component carrier 150 with an embedded metal structure 100, according to an exemplary embodiment of the invention. The component carrier 150 comprises an upper stack 155a and a lower stack 155b, wherein the metal structure 100 is embedded (sandwiched) between the upper stack 155a and the lower stack 155b. Each stack 155a, 155b is a layer build-up structure and comprises a plurality of electrically conductive layer structures 152 and a plurality of electrically insulating layer structures 154. Additionally the component carrier 150 may comprise at least one component surface mounted and/or embedded inside the component carrier.

In an example, the metal structure 100 can serve as a core layer and the stacks 155a, 155b are build-up directly on the core layer. In another example, the pre-manufactured stacks 155a, 155b are attached to the metal structure 100. In a further example the first metal layer structure 110 is manufactured together with the upper stack 155a, and the second metal layer structure 120 is manufactured together with the lower stack 155b. Alternatively, the first and/or second metal layer structure 110, 120 is attached to a temporary carrier for forming the recesses. After stacking the first metal layer structure 110 over the second metal layer structure 120, the temporary carrier may be removed. Then, the first metal layer structure 110 and the second metal layer structure 120 are stacked to form the component carrier 150. It can be seen that the first metal layer structure 110 and the second metal layer structure 120 are directly connected one to each other.

In this example, the common recess 130 defines a waveguide and/or a fluid-tight channel in the component carrier 150.

**Figure 5** shows a component carrier 150 with a surface-mounted metal structure 100, according to an exemplary embodiment of the invention. This embodiment is comparable with the one described for Figure 4 with the difference being that the metal structure 100 is not embedded/sandwiched in the stack but arranged on the stack 155. The metal structure 100 can serve as a robust support for the stack 155 or the other way around. In this example, the common recess 130 defines a waveguide and/or a fluid-tight channel on the component carrier 150.

**Figure 6** shows a component carrier 150 with a surface-mounted metal structure 100 that comprises openings 135, according to an exemplary embodiment of the invention. The metal structure 100 is arranged on top of the stack 155 (surface-mounted) like in Figure 5. Yet, in the example of Figure 6, at least one (in particular each) common recess 130 is connected to an opening 135 (with a smaller diameter than the respective common recess 130). In this example, the openings 135 are formed as through-holes in the first layer structure 110. The openings 135 are configured here as slots/slits, so that a slot antenna functionality can be fulfilled by the common recesses 130.

**Figure 7** shows a component carrier 150 with a metal structure 100 that comprises an embedded transmission line as an intermediate layer 140, according to an exemplary embodiment of the invention. Here, the first metal layer structure 110 and the second metal layer structure 120 are indirectly connected one to each other by an intermediate layer 140. The intermediate layer 140 is sandwiched between the first metal layer structure 110 and the second metal layer structure 120 and defines a strip inside the common recess that is at least partially configured for signal feeding.

A thin insulating material, e.g. prepreg, (preferably a low Dk/Df material) may carry the transmission line and/or coupling structure(s). In addition, shielding vias 146 are shown to "close" the channels as they interrupt the insulating material.

The metal structure 100 further comprises a plurality of components 145 (e.g. RF components), arranged on the intermediate layer 140 in the common recesses 130, respectively.

A transmission line may be a stripline, preferably on a thin low Dk/Df material). A suspended stripline may be a transmission line enclosed by e.g. two shielded cavities.

In the metal material structures (pillars) between the common recesses 130, respective electrically conductive interconnections 146 (vias) are formed. The intermediate layer 140 is hereby an electrically insulating layer.

In an example, the electrically conductive interconnections 146 may comprise metal, in particular copper or silver, or a metal comprising paste, for example a sinter paste.

In another example, the electrically conductive interconnections 146 may extend into the first metal layer structure 110 and/or the second metal layer structure 120. This may bring the advantage of enhancing the interaction, for example adhesion, between the electrically conductive interconnections 146 and the first metal layer structure 110 and/or second metal layer structure 120 and thus may enhance the integrity of the component carrier. Optionally, between the electrically conductive interconnections 146 and the first metal layer structure 110 and/or the second metal layer structure 120 an adhesion promotor may be located.

**Figure 8** shows an antenna assembly 200, according to an exemplary embodiment of the invention. The antenna assembly 200 comprises two parts: a multilayer stack 210 (a component carrier) (this stack can be different from the component carrier 150 stack) and an antenna structure 220, wherein the stack 210 is mounted on the antenna structure 220.

The stack 210 comprises in this embodiment a central core layer structure 213 sandwiched between an upper build-up layer structure (stack) 211 and a lower build-up layer structure (stack) 212. During the manufacture process, the build-up may be done on the upper main surface and the opposed lower main surface of the core layer structure 213, e.g. by lamination of resin (in particular prepreg) layers. The stack 210 (in particular the build-ups 211, 212) comprises a plurality of electrically insulating layer structures 202 and a plurality of electrically conductive layer structures 204 alternating with each other. The electrically conductive layer structures 204 are configured here as a redistribution layer structure that comprises traces/pads and blind vias.

At least one component 230, here two radio frequency integrated circuits, are embedded in the stack 210; specifically both components are embedded side-by-side (on the same vertical level) in the core layer structure 213. Through vias 217 extend through said core layer structure 213 and (electrically) interconnect the (electrically conductive layer structures 204 of the) upper stack 211 and the lower stack 212. The redistribution layer structure can serve to translate small electric contacts of the embedded components 230 to larger electric contacts at the external surface of the stack 210.

Portions of the electrically conductive layer structure 204 (of the lower build-up 212) are provided at the external side of the stack 210. Some of said portions are used to (electrically) interconnect the stack 210 and the antenna structure 220, in this example via solder balls 216. Yet, other portions of the electrically conductive layer structure 204 are configured to act as part of an electromagnetic wave coupling structure 215. In other words, these electromagnetic wave coupling structures 215 fulfill the function of a launcher, respectively.

The antenna structure 220 can be configured as a layer stack 223 (layers not shown) or as a compact structure (without layers). The antenna structure 220 comprises an opening 225 to a channel 221 that passes in the vertical direction (along the direction of gravity) through the antenna structure 220. The channel 221 vertically extends through the entire antenna structure 220, here in an L-shape.

The stack 210 and the antenna structure 220 are arranged and connected to each other, so that a specific electromagnetic wave coupling structure 215 and a respective opening 225 to the channel 221 face each other (are aligned in the vertical direction and (at least partially) overlap).

The extremity of the channel 221, opposed to the opening 225 faced to the electromagnetic wave coupling structure 215, comprises an opening structure 222, here two slots, configured as a wave emitter/receiver. There is further arranged an electrically conductive coupling layer structure 226 comprising at least one aperture 222 (in this example, the aperture is identical to the slot) being in communication with the opening 225 of the antenna structure 220. The internal walls 224 of the channel 221 are coated by a metal. The channel 225 can be at least partially formed by a metal structure 100 according to Figure 1.

The electromagnetic wave coupling structure 215 is configured here as a launcher comprising a conductive layer structure. Said conductive layer structure is provided on a second electrically insulating layer structure 218 of the stack 210, wherein the second electrically insulating layer structure 218 comprises a material different from that of the other electrically insulating layer structures 202, preferably a high frequency material.

It can be further seen that the launcher 215 planar extension is smaller than the planar extension of the opening 225 of the antenna structure 220 and that the launcher 215 is directly facing the waveguide 225.

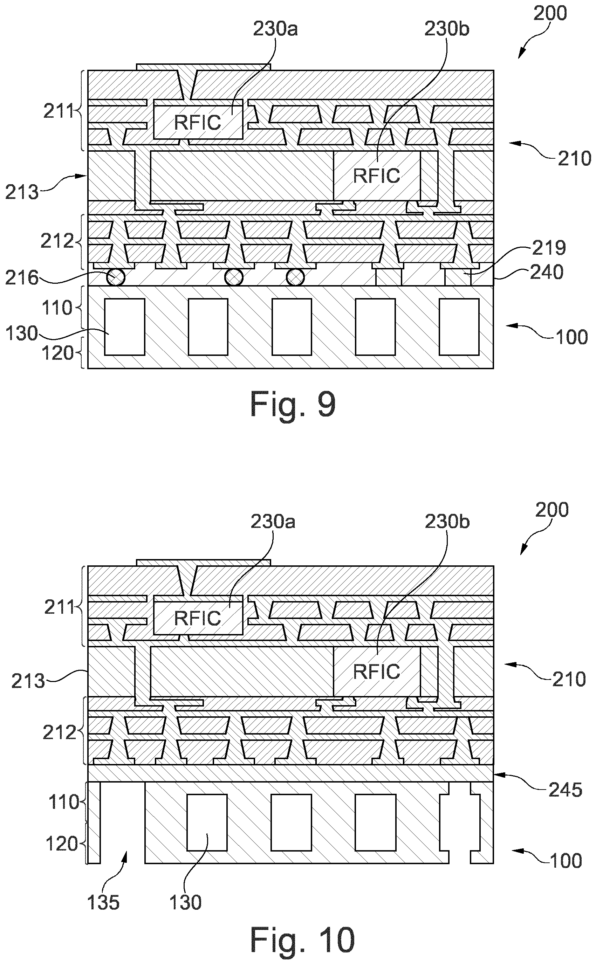

**Figure 9** shows a component carrier 200 with a stack 210 and a metal structure 100, according to an exemplary embodiment of the invention. The stack 210 can be comparable with the one described for Figure 8. Yet, a first component 230a is embedded in the upper build-up structure 211, while a second component 230b is embedded in the core layer structure 213, as in case of Figure 8.

Further, in comparison to Figure 8, the stack 210 is not coupled with an antenna structure 220 (by wave coupling structures 215) but instead with the metal structure 100. The outermost layer of the lower build-up structure 212 is coupled (interconnected) with the upper main surface of the metal structure 100 through an intermediate layer structure 240. The intermediate layer structure 240 can be an electrically insulating structure, for example low flow prepreg and/or low Dk/Df material. Between exposed electric connections of the stack 210 and the metal structure 100, there are arranged solder balls 216 and further interconnection structures 219, for example sinter paste (may be any metal paste), conductive paste, nanowires, or a thermal prepreg, for example.

The connection structures 216/219 through the intermediate layer structure 240 can be partially applied for the RF signal and partially (or fully) applied as cooling channels/paths. In this embodiment, the metal structure 100 may be used as a heatsink (in addition to the RF signal functionality).

**Figure 10** shows a component carrier 200 with a stack 210 and a metal structure 100 with openings 135, according to an exemplary embodiment of the invention. The example of Figure 10 is comparable with the one of Figure 9. Yet, the intermediate layer structure 240 is realized without (inter) connection structures, but for example as a conductive paste (layer structure) 245 or nanowires. The openings may be comparable to those of Figure 6 (formed by through holes) and may be configured for signal entrance and emission. Below the entrance slot there may be for example a coupling structure (such as a pad) of the stack 210. Even though the metal structure 100 may serve thermal purposes in this example, an additional antenna functionality may be provided, being eventually more versatile than in the example of Figure 9 (due to the openings 135).

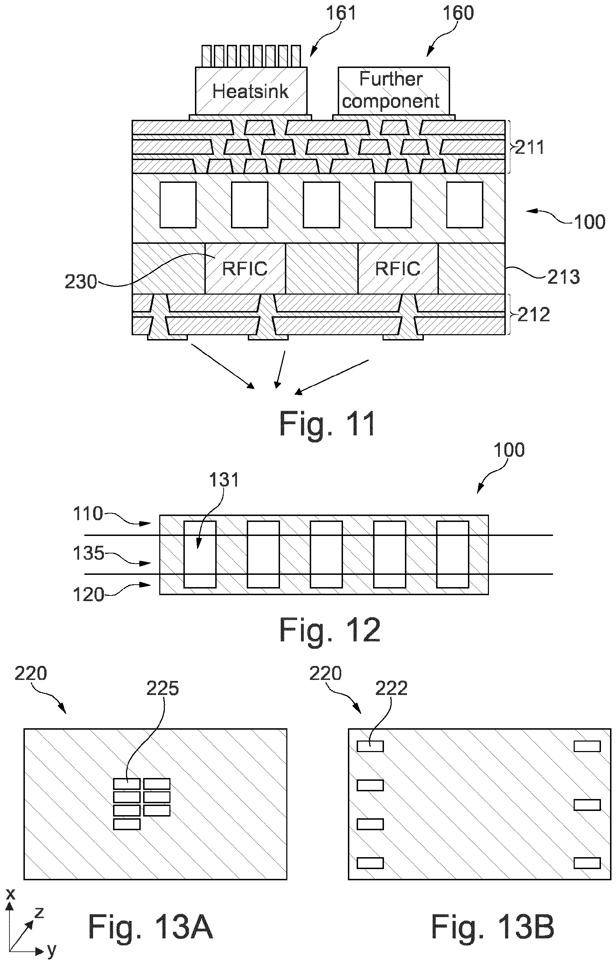

**Figure 11** shows a component carrier 200 with a stack 210, an embedded metal structure 100, and further surface-mounted components 160, 161, according to an exemplary embodiment of the invention. In comparison to the examples of Figures 8 to 10, the metal structure 100 is hereby embedded in the stack and not attached to a main surface of the stack. The core layer structure 213 with two embedded components 230 is comparable to Figure 8, however, the metal structure 100 is directly placed on top of said core layer structure 213. Below the core layer structure 213, there is arranged the lower build-up structure 212. On top of the metal structure 100, there is arranged the upper build-up structure 211.

On top of the upper build-up structure 211, there is surface mounted a further component 160, e.g. a semiconductor element, and a heat sink 161 (here with heat fins). It can be seen that the heat sink 161 and the further component 160 are directly connected to vias of the upper build-up structure 211.

The lower build-up structure 212 is configured in this example to emitting electromagnetic waves (RF signals) towards a path antenna (schematically illustrated by arrows).

**Figure 12** shows a metal structure 100 with three metal layer structures 110, 135, 120, according to an exemplary embodiment of the invention. In this example, three metal layer structures have been stacked on top of each other. The central metal layer structure 135 comprises exclusively through holes, so that a plurality of common recesses 130 can be formed side-by-side, when (directly) stacking the first metal layer structure 110, the central metal layer structure 135, and the second metal layer structure 120 on top of each other.

Figures 13A and 13B respectively show a top view on an antenna structure 220 (see Figure 8), according to an exemplary embodiment of the invention.

**Figure 13A****:** this is a top view on the upper main surface (facing the stack for signal entrance) of the antenna structure 220 of Figure 8, which shows the openings 225. Seven slots corresponding to seven RF channels, respectively, are shown. There can be e.g. three transmitting channels and four receiving channels. In an example, the number of channels can be significantly increased, e.g. to 64 or more.

**Figure 13B****:** this is a top view on the lower main surface (facing the environment) of the antenna structure 220 of Figure 8, which shows the opening structures (apertures, slots) 222. As can be seen in Figure 8, these are connected within the antenna structure 220 through channels 221 to the respective opening 225. Hereby, opening 225 and corresponding opening structures 222 are not at the same position. Seven slots correspond to seven RF channels 221. Inside the antenna structure 220, three transmitting channels are routed in a way that the escape slot is on one side (on the right side) of the antenna structure 220; whereas the four receiving channels are routed in a way that they are located on the opposite (left side) of the antenna structure 220.

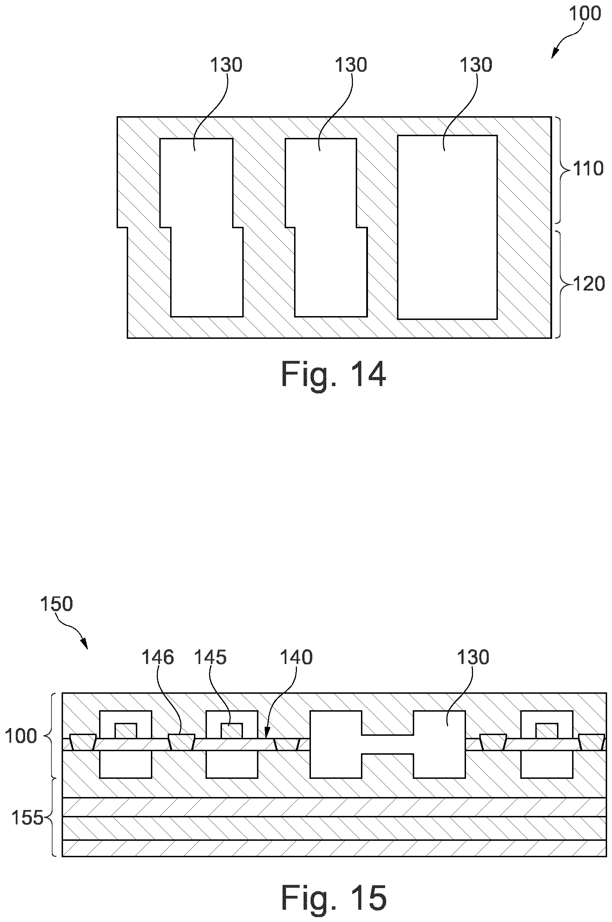

**Figure 14** shows a metal structure 100 according to a further exemplary embodiment of the invention. The two common recesses 130 at the left side and in the middle respectively comprise an edge structure (misalignment), whereas a further common recess located adjacent to the common recesses 130 at the right side, is free from an (further) edge structure. This structure may result from inaccuracies of the etching process.

**Figure 15** shows a component carrier 150 with a metal structure 100 that comprises an embedded transmission line as an intermediate layer 140, according to a further exemplary embodiment of the invention. This embodiment is comparable to Figure 7 but comprises two neighbouring (and connected) cavities (common recesses) without the transmission line 140. Said empty cavities could be used for example for different purposes, e.g. cooling channels and waveguides alternatingly.

### Reference signs

- 100: Metal structure
- 110: First metal layer structure
- 111: First recess
- 112: First metal material structure, pillar
- 114: Through recess
- 115: First external boundary profile
- 120: Second metal layer structure
- 121: Second recess
- 122: Second metal material structure, pillar
- 125: Second external boundary profile
- 130: Common recess
- 135: Central metal layer structure
- 140: Intermediate layer
- 145: Component
- 146: Conductive interconnections
- 150: Component carrier
- 152: Electrically insulating layer structure
- 154: Electrically conductive layer structure
- 155: Stack
- 160: Further component
- 161: Heat sink
- 180: Undercut

- 200: Antenna assembly
- 202: Electrically insulating layer structure
- 204: Electrically conductive layer structure
- 210: Stack
- 211: Upper build-up
- 212: Lower build-up
- 213: Core layer structure
- 215: Electromagnetic wave coupling structure
- 216: Connection structure, solder ball
- 217: Electrically conductive vertical connection
- 218: Second electrically insulating layer structure
- 219: Interconnection structures
- 220: Antenna structure
- 221: Channel, waveguide
- 222: Opening structure, aperture, slot
- 223: Antenna structure body, antenna structure stack
- 224: Internal wall
- 225: Opening
- 226: Coupling electrically conductive layer structure
- 240: Intermediate layer structure
- 245: Conductive paste layer structure

## Claims

1. A metal structure (100) for a component carrier (150), wherein the metal structure (100) comprises:
a first metal layer structure (110) comprising a first recess (111) exposed to a first surface and defining a first external boundary profile (115); and
a second metal layer structure (120) comprising a second recess (121) exposed to a second surface and defining a second external boundary profile (125);
wherein the first metal layer structure (110) and the second metal layer structure (120) are stacked to face each other, so that the first recess (111) and the second recess (121) define a common recess (130); and
wherein the first external boundary profile (115) of the first recess (111) and the second external boundary profile (125) of the second recess (121) are misaligned in the stacking direction (Z) of the metal structure (100).

2. The metal structure (100) according to claim 1, wherein the common recess (130) has an irregular profile, in particular along the stacking direction (Z).

3. The metal structure (100) according to claim 1 or 2, wherein the common recess (130) has at least one rounded portion.

4. The metal structure (100) according to one of the preceding claims,
wherein the width of the recesses (111, 121) between the two boundary profiles (115, 125) is smaller than the width of an intermediate portion of the common recess (130) along the stacking direction (Z).

5. The metal structure (100) according to one of the preceding claims,
wherein the common recess (130) has an irregular profile, in particular along the planar direction (X,Y).

6. The metal structure (100) according to one of the preceding claims,
wherein the first recess (111) and/or the second recess (121) extends along a linear direction (L), wherein the deviation of the first external boundary profile (115) and/or the second external boundary profile (125) of the respective recess (111, 121) or the deviation between the distance of the respective first external boundary profile (115) and the second external boundary profile (125) is 100 µm or lower, in particular 50 µm or lower, in particular in the range 5 to 100 µm.

7. The metal structure (100) according to one of the preceding claims,
wherein the misalignment along the stacking direction (Z) of the metal structure (100) comprises an edge, in particular a sharp edge, structure exposed inside the common recess (130).

8. The metal structure (100) according to one of the preceding claims, further comprising:
a further first recess in the first metal layer structure (110) and/or a further second recess in the second metal layer structure (120),
in particular
wherein the first recess (111) and the further first recess have a different shape; and/or
wherein the second recess (121) and the further second recess have a different shape.

9. The metal structure (100) according to one of the preceding claims,
wherein the common recess (130) defines a fluid-tight channel.

10. The metal structure (100) according to one of the preceding claims,
wherein the first metal layer structure (110) and the second metal layer structure (120) are directly connected one to each other; or
wherein the first metal layer structure (110) and the second metal layer structure (120) are indirectly connected one to each other by at least one intermediate layer (140),
in particular
wherein the at least one intermediate layer (140) is sandwiched between the first metal layer structure (110) and the second metal layer structure (120); and/or
wherein the at least one intermediate layer (140) comprises an electrically conductive layer structure and/or an electrically insulating layer structure; and/or
wherein the at least one intermediate layer (140) defines a strip inside the common recess (130); and/or
wherein the at least one intermediate layer (140) is at least partially configured as an antenna.

11. The metal structure (100) according to one of the preceding claims,
wherein the first metal layer structure (110) and/or the second metal layer structure (120) comprises a through recess (114),
in particular
wherein the through recess (114) extends along two different directions along the stacking direction (Z); or
wherein the through recess (114) extends along one direction along the stacking direction (Z), in particular along a straight direction.

12. A component carrier (150), comprising:
a stack (155) comprising at least one electrically insulating layer structure (152) and at least one electrically conductive layer structure (154); and
a metal structure (100) according to one of the preceding claims;
wherein the metal structure (100) is assembled to the stack (155), in particular embedded or surface-mounted.

13. An antenna structure (220), comprising:
an opening (210) and/or a channel (225) through at least a part of the antenna structure (200); and
a metal structure (100) according to one of the preceding claims;
wherein the common recess (130) of the metal structure (100) defines at least part of said opening (210) and/or channel (225).

14. An antenna assembly (200), comprising:
a stack (210) comprising at least one electrically insulating layer structure (202) and at least one electrically conductive layer structure (204); and
an antenna structure (220) according to claim 13, coupled with the stack (210).

15. A method of forming a metal structure (100) for a component carrier (150), the method comprising:
etching a first metal layer structure (110) to form a first recess (111) exposed to a first surface and defining a first external boundary profile (115);
etching a second metal layer structure (120) to form a second recess (121) exposed to a second surface and defining a second external boundary profile (125); and
stacking the first metal layer structure (110) and the second metal layer structure (120) to face each other, so that the first recess (111) and the second recess (121) define a common recess (130).
